# DEMANDE DE BREVET EUROPEEN

(11) **EP 0 930 815 A1**
(43) Date de publication de la demande: **21.07.1999**
(21) Numéro de dépôt: 99420011.1
(22) Date de dépôt: 18.01.1999
(51) Int. Cl.: H05K 7/20, H01L 23/473

(54) **Composant électronique de puissance et son procédé de fabrication**

(30) Priorité: 19.01.1998 FR 9800745
(71) Demandeur: Ferraz Date Industries, 38350 La Mure (FR)
(72) Inventeur: Rubichon, Yvan, 38160 Saint Marcellin (FR); Sarrus, Franck, 69100 Villeurbanne (FR); Bonhomme, Christian, 69720 Saint Bonnet de Mure (FR)
(74) Mandataire: Myon, Gérard Jean-Pierre

(57) **Abrégé**

Le composant (1) comprend plusieurs puces (2) de silicium supportées par une plaque (30), elle-même disposée en regard d'un boîtier (7) d'un échangeur de chaleur (6). Le boîtier (7) et la plaque (3) sont surmoulés dans un revêtement (13) en matériau électriquement isolant alors qu'une entretoise (11) de dilatation est placée entre le boîtier (7) et la plaque (3) et qu'un cadre (12) est disposé autour du revêtement (13) en matériau électriquement isolant. Le cadre supporte un couvercle (14) apte à exercer sur la plaque un effort de poussée (F) en direction de l'entretoise de dilatation (11).

## Description

L'invention a trait à un composant électronique de puissance et à son procédé de fabrication.

Un composant électronique de puissance peut être utilisé dans les circuits de distribution d'énergie, notamment dans le domaine ferroviaire. Un exemple d'un tel composant est connu sous la dénomination IGBT (Insulated Gate Bipolar Transistor). Compte tenu des valeurs de la tension et du courant délivrés par ce composant, il est susceptible de s'échauffer. Il est connu d'accoupler à ce genre de composant un échangeur de chaleur tel que décrit, notamment, dans les documents EP-A-0 611 235 ou FR-A-2 748 800.

Du fait de leur fonctionnement, les composants électroniques de puissance sont portés à un potentiel sensiblement différent de celui de la terre, de l'ordre de plusieurs kilovolts, alors que les échangeurs de chaleur qui leurs sont associés sont métalliques et doivent demeurer au potentiel de la terre, en particulier du fait qu'ils contiennent un liquide conducteur.

Pour isoler électriquement un échangeur de chaleur d'un composant électronique de puissance porté à la haute tension, il est connu d'insérer entre ces deux éléments une plaque d'isolation en céramique, par exemple en alumine ou en nitrure d'aluminium. La forme de cette plaque est adaptée à la surface de l'échangeur en regard du ou des composants. Selon cette approche, le composant constitue une structure multicouche pourvue d'une armature, cette armature étant en appui sur une plaque d'isolation elle-même au contact de l'échangeur de chaleur. Cette superposition de plusieurs couches nuit à l'efficacité du transfert thermique et augmente le prix de revient total du dispositif.

En outre, les dimensions transversales de l'ensemble formé du composant et de l'échangeur auquel il est associé sont relativement importantes. Enfin, pour garantir un transfert thermique efficace sur toute la surface du composant et de l'échangeur, il convient d'exercer un effort de pression réparti sur cette surface. Pour ce faire, il est nécessaire de soumettre l'ensemble du composant à un effort de clampage de l'ordre de 5 tonnes.

C'est à ces inconvénients qu'entend plus particulièrement remédier l'invention en proposant une structure de composant électronique de puissance qui permet un échange de chaleur efficace alors que le prix de revient et les dimensions transversales du composant sont diminués par rapport à l'art antérieur.

Dans cet esprit, l'invention concerne un composant électronique de puissance comprenant plusieurs puces de silicium supportées par une plaque, cette plaque étant disposée en regard d'un échangeur de chaleur comprenant un boîtier définissant un espace intérieur de circulation d'un fluide caloporteur, caractérisé en ce que le boîtier et la plaque sont surmoulés dans un revêtement en matériau électriquement isolant, une entretoise de dilatation étant placée entre le boîtier et la plaque alors qu'un cadre disposé autour du revêtement en matériau électriquement isolant supporte au moins un couvercle apte à exercer sur la plaque un effort de poussée en direction de l'entretoise de dilatation.

Grâce à l'invention, le composant électronique est intégré avec l'échangeur de chaleur alors que le cadre et le couvercle permettent de répartir un effort de poussée sur la surface de la plaque en contact avec l'échangeur de chaleur. Ceci favorise le transfert thermique entre les puces de silicium et le liquide caloporteur. Le matériau électriquement isolant surmoulé autour du boîtier et de la plaque permet d'éviter les courants de cheminement dans le dispositif et contribue au positionnement précis de ses éléments constitutifs. L'entretoise de dilatation autorise un glissement relatif de la plaque et du boîtier de l'échangeur de chaleur, ce qui est nécessaire compte tenu des coefficients de dilatation thermique potentiellement différents de ces deux éléments.

Selon un premier aspect avantageux de l'invention, des moyens élastiques de poussée de la plaque sont prévus entre le couvercle et la plaque. Ces moyens élastiques permettent une répartition de l'effort de poussée sur la surface de la plaque. Avantageusement, ces moyens élastiques sont constitués par des ressorts disposés entre la plaque et le couvercle. On peut notamment prévoir que le couvercle et/ou la plaque portent des moyens d'immobilisation transversale des ressorts.

Selon une première variante, les moyens élastiques sont collés sur le couvercle ou la plaque.

Selon une seconde variante, le volume défini entre le cadre, la plaque et le couvercle est rempli de mousse expansible. Cette mousse permet de transmettre l'effort de poussée du couvercle à la plaque.

Selon un autre aspect avantageux de l'invention, le composant comprend deux plaques disposées de part et d'autre du boîtier de l'échangeur de chaleur, le cadre se prolongeant de part et d'autre des plaques et supportant deux couvercles aptes chacun à exercer un effort de poussée sur une des plaques en direction d'une entretoise de dilatation. Cet aspect de l'invention permet de réaliser un composant double avec un unique échangeur de chaleur, ce qui confère à l'ensemble une très bonne compacité.

L'invention concerne également un procédé de fabrication d'un composant tel que précédemment décrit qui consiste à :
- disposer la plaque au contact d'une première face d'une entretoise de dilatation ;
- disposer un boîtier d'un échangeur de chaleur au contact d'une seconde face de cette entretoise ;
- surmouler l'ensemble ainsi formé dans un matériau électriquement isolant à l'intérieur d'un cadre et
- monter sur ledit cadre au moins un couvercle apte à exercer sur ladite plaque un effort de poussée en direction de ladite entretoise de dilatation.

Avantageusement, le procédé consiste également à maintenir l'ensemble ainsi formé par rapport au cadre avant surmoulage par insertion d'au moins un raccord de connexion fluidique du boîtier avec un circuit de circulation de fluide caloporteur.

Selon un autre aspect avantageux, le procédé consiste à introduire dans l'espace intérieur défini par le cadre, la plaque et le couvercle un moyen élastique de poussée sur la plaque.

L'invention sera mieux comprise et d'autres avantages de celle-ci apparaîtront plus clairement à la lumière de la description qui va suivre de trois modes de réalisation d'un composant électronique de puissance conforme à son principe, donnée uniquement à titre d'exemple et faite en référence aux dessins annexés dans lesquels :
- la figure 1 est une coupe schématique de principe d'un composant électronique de puissance conforme à un premier mode de réalisation de l'invention ;
- la figure 2 est une coupe analogue à la figure 1 pour un composant conforme à un second mode de réalisation de l'invention ;
- la figure 3 est une coupe analogue à la figure 1 pour un composant conforme à un troisième mode de réalisation de l'invention et
- la figure 4 est une vue en perspective éclatée du composant de la figure 3.

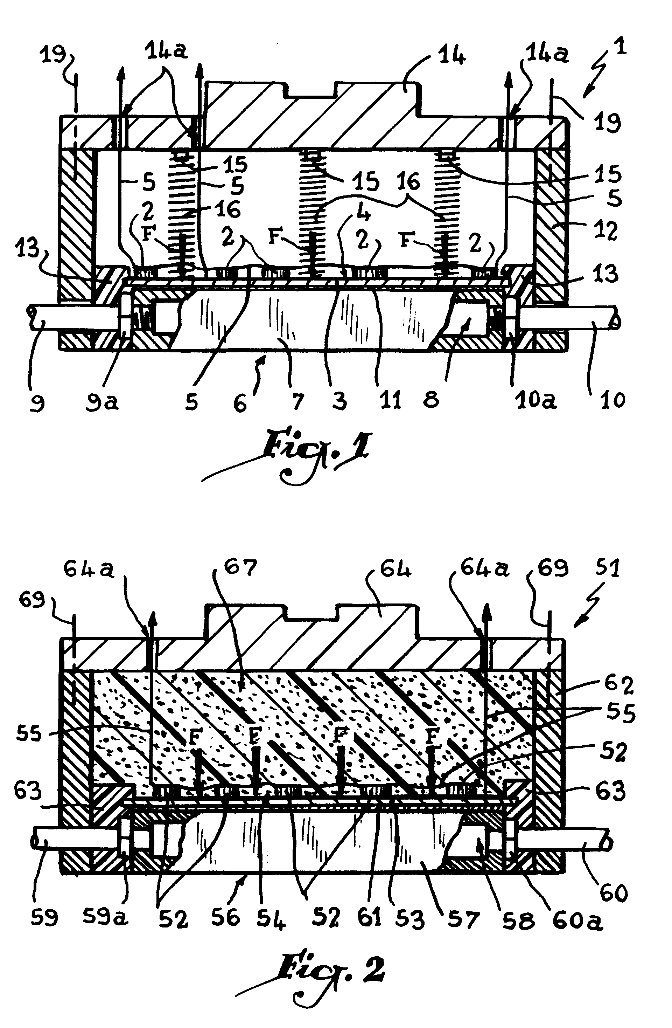

A la figure 1, un composant IGBT 1 comprend plusieurs puces de silicium 2 disposées sur une plaque support en céramique 3 grâce à des brasures 4. Des fils électriques 5 permettent la circulation d'un courant de puissance ou d'un courant de commande entre les puces 2 et en direction ou en provenance de l'extérieur. Un échangeur de chaleur 6, formé d'un boîtier 7 définissant un volume intérieur 8 de circulation d'un fluide caloporteur est relié à des canalisations 9 et 10 de circulation de ce fluide par des raccords 9a et 10a.

Une entretoise de dilatation 11 est disposée entre les faces en regard de la plaque 3 et du boîtier 7. Cette entretoise est réalisée dans une feuille de graphite souple commercialisée par la société CARBONE LORRAINE sous la marque "PAPYEX" (marque déposée). Elle a une épaisseur comprise entre 0,1 et lmm. En pratique, une épaisseur comprise entre 0,2 et 0,5 mm est suffisante pour remplir la fonction recherchée. Le caractère souple du graphite utilisé pour l'entretoise 11 lui permet de compenser de légères variations de cote ou des irrégularités de surface de la plaque 3 ou du boîtier 7. Le graphite souple a un faible coefficient de frottement avec le métal du boîtier 7 et avec la matière constitutive de la plaque 3, telle que par exemple de l'alumine ou du nitrure d'aluminium, de sorte qu'un glissement relatif de ces deux éléments est possible, en particulier par suite des dilatations différentielles obtenues en cas d'augmentation sensible de la température de l'ensemble du composant 1.

L'entretoise 11 pourrait également être réalisée en métal, tel que par exemple en aluminium, ou en alumine, éventuellement chargée en fibres de carbone. Divers autres matériaux peuvent être choisis pour réaliser l'entretoise 11 en fonction de leur coefficient de friction avec la plaque 3 et le boîtier 7.

Un cadre 12 est disposé autour de l'ensemble formé par les éléments 3, 7 et 11. Les raccords d'extrémité 9a et 10a des canalisations 9 et 10 traversent le cadre 12 pour permettre le branchement du volume intérieur 8 de l'échangeur 6 avec ces canalisations.

Une masse 13 d'élastomère est surmoulée autour de l'ensemble formé des éléments 3, 7, 11, 9a et 10a à l'intérieur du cadre 12. Cette masse de matériau électriquement isolant permet d'éviter le cheminement de l'électricité, ce qui permet aux composants conformes à l'invention de fonctionner à des tensions de l'ordre de 6 kV. et de résister à une séquence de test à 12 kV pendant une minute.

Un couvercle 14 est fixé sur le cadre 12 par des vis 19 et comprend des orifices 14a de passage des câbles 5. Sur sa face tournée vers la plaque 3, le couvercle 14 porte des pions 15 autour desquels sont disposées les extrémités supérieures de ressorts 16 dont l'extrémité inférieure vient en appui contre la face de la plaque 3 opposée à l'entretoise 11.

Ainsi, les ressorts 16 transmettent un effort de poussée F du couvercle 14 à la plaque 3, ce qui garantit un appui efficace de la plaque sur l'entretoise 11, de l'entretoise sur le boîtier 7 et, par voie de conséquence, un transfert thermique efficace avec le boîtier 7 à travers l'entretoise 11.

Divers moyens élastiques peuvent être disposés entre les pions 15 et la plaque 3. On peut, par exemple, utiliser des entretoises souples, des tiges flexibles, des joints pneumatiques, des ressorts en élastomère ou en caoutchouc, des ressorts à rondelles ou hélicoïdaux...

Dans le second mode de réalisation de l'invention représenté à la figure 2, les éléments analogues à ceux du mode de réalisation de la figure 1 portent des références identiques augmentées de 50. Le composant 51 représenté à la figure 2 comprend des puces de silicium 52 réparties sur une plaque 53 à laquelle elles sont fixées grâce à des brasures 54. Une entretoise de dilatation 61 est disposée entre la plaque 53 et un boîtier 57 définissant un volume intérieur 58 d'un échangeur de chaleur 56. Des fils de commande et de puissance 55 relient les puces 52 à l'extérieur du composant 51 à travers des orifices 64a d'un couvercle 64 fixé à un cadre 62 par des vis 69. Des canalisations 59 et 60 sont reliées au volume intérieur 58 de l'échangeur 56 grâce à des raccords 59a et 60a. Le cadre 62 est disposé autour de l'ensemble formé des éléments 53, 57 et 61 alors qu'une masse 63 de matériau électriquement isolant, tel qu'un élastomère, est surmoulée entre cet ensemble et le cadre 62.

Une masse 67 de mousse de expansible et élastique remplit l'espace défini entre la plaque 53, le cadre 62 et le couvercle 64, de telle sorte qu'elle transmet un effort F du couvercle 64, réparti sur la plaque 53, en direction de l'entretoise 61.

Divers types de mousse peuvent être utilisés, tels que, par exemple, de la mousse de polystyrène ou de polyuréthane.

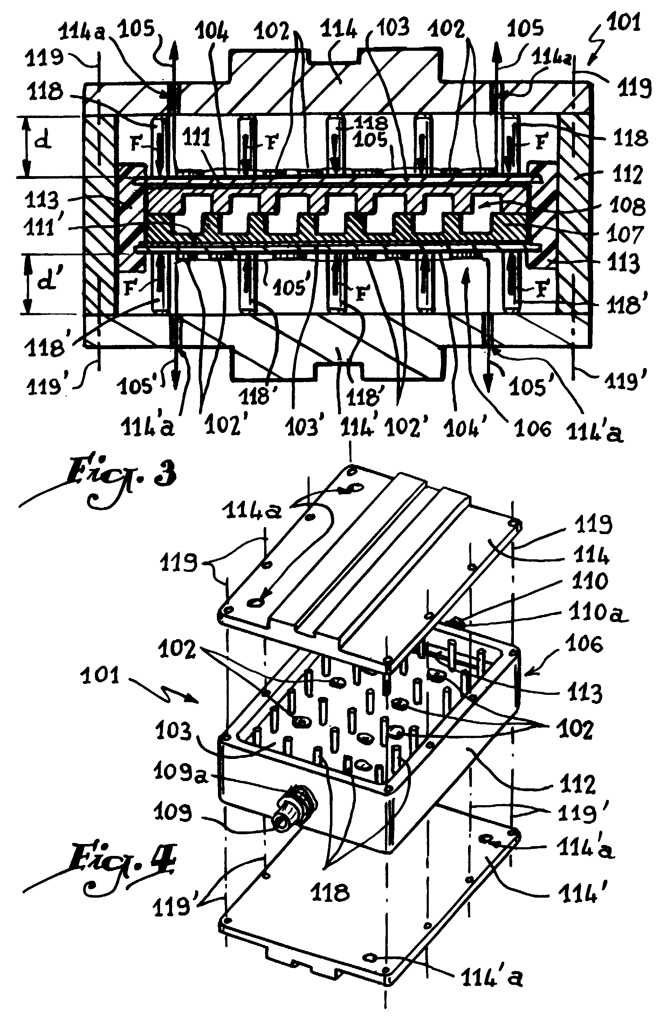

Dans le troisième mode de réalisation de l'invention représenté aux figures 3 et 4 les éléments analogues à ceux du mode de réalisation de la figure 1 portent des références identiques augmentées de 100. Dans ce mode de réalisation, un composant électronique 101 comprend des puces de silicium 102 et 102' supportées par deux plaques 103 et 103' auxquelles elles sont raccordées par des brasures 104 et 104'. Un échangeur de chaleur 106 est disposé entre les plaques 103 et 103'. Plus précisément, le boîtier 107 de l'échangeur 106, qui définit un volume intérieur 108 de circulation d'un fluide caloporteur, est disposé entre deux entretoises de dilatation 111 et 111' tout en étant raccordé à des canalisations 109 et 110 par des raccords 109a et 110a. Des fils électriques 105 et 105' permettent la commande et la transmission de puissance aux puces 102 et 102'.

Un cadre 112 est disposé autour de l'ensemble formé des éléments 103, 103', 107, 111 et 111' alors qu'une masse d'élastomère 113 est surmoulée entre cet ensemble et le cadre 112.

Deux couvercles 114 et 114' sont portés par le cadre 112 et pourvus d'orifices 114a, 114'a de passage des fils 105, 105'. Des entretoises élastiques 118 et 118' sont respectivement collées à la surface des plaques 103 et 103' et s'étendent en direction des couvercles 114 et 114'. Ces entretoises peuvent être réalisées en polyéthylène ou en tout autre matériau élastique. Elles ont une cote légèrement supérieure à la distance d ou d' qui sépare le couvercle 114 ou 114' de la plaque correspondante 103 ou 103' en position montée. Ainsi, les entretoises élastiques 118 sont comprimées par la mise en place des couvercles 114 ou 114' sur le cadre 112. Ceci a pour effet de transmettre aux plaques 103 et 103' un effort de poussée F dirigé vers les entretoises de dilatation 111 et 111'.

La fabrication d'un composant électronique de puissance conforme à l'un des trois modes de réalisation décrits est simple, dans la mesure où il suffit de constituer un ensemble formé d'une plaque support de puces de silicium et d'un boîtier d'un échangeur de chaleur entre lesquels est disposée une entretoise de dilatation et de surmouler cet ensemble à l'intérieur d'un cadre.

Avantageusement, pour maintenir, avant surmoulage des masses d'élastomère 13, 63 ou 113, l'ensemble formé de la plaque du boîtier et de l'entretoise en position par rapport au cadre, on met en place les raccords 9a, 10a, 59a, 60a, 109a ou 110a en position dans les orifices correspondants du boîtier 7, 57 ou 107 et du cadre 12, 62 ou 112. On est alors dans la position de la figure 4 dans laquelle il est possible de mettre en place les entretoises 118 sur la plaque 103 ou 103' dans les espaces laissés libres par les puces 102. Il serait également possible de mettre en place des ressorts équivalents aux ressorts 16 du premier mode de réalisation. Lorsque ces moyens élastiques de pression sont en place, on peut rapporter le couvercle 14, 64, 114 ou 114' sur le cadre correspondant au moyen de vis 119 et 119' ou équivalent.

Dans le mode de réalisation représenté aux figures 3 et 4, le composant comprend deux plaques 103 et 103' disposées de part et d'autre du boîtier 107 de l'échangeur 106, ce qui lui confère une très bonne compacité.

## Revendications

1. Composant électronique de puissance (1 ; 51 ; 101) comprenant plusieurs puces de silicium (2 ; 52 ; 102, 102') supportées par une plaque (3 ; 53 ; 103 ; 103'), ladite plaque étant disposée en regard d'un échangeur de chaleur (5 ; 56 ; 106) comprenant un boîtier (7 ; 57 ; 107) définissant un espace intérieur (8 ; 58 ; 108) de circulation d'un fluide caloporteur, caractérisé en ce que ledit boîtier et ladite plaque sont surmoulés dans un revêtement (13 ; 63 ; 113) en matériau électriquement isolant, une entretoise de dilatation (11 ; 61 ; 111, 111') étant placée entre ledit boîtier et ladite plaque alors qu'un cadre (12 ; 62 ; 112) disposé autour dudit revêtement en matériau électriquement isolant supporte au moins un couvercle (14 ; 64 ; 114, 114') apte à exercer sur ladite plaque un effort de poussée (F) en direction de ladite entretoise de dilatation.

2. Composant selon la revendication 1, caractérisé en ce que des moyens élastiques (16 ; 67 ; 118) de poussée de ladite plaque (3 ; 53 ; 103, 103') sont prévus entre ledit couvercle (14 ; 64 ; 114, 114') et ladite plaque.

3. Composant selon la revendication 2, caractérisé en ce que lesdits moyens élastiques sont constitués par des ressorts (16) disposés entre ladite plaque (3) et ledit couvercle (14).

4. Composant selon la revendication 3, caractérisé en ce que ledit couvercle (14) et/ou ladite plaque (3) portent des moyens (15) d'immobilisation transversale desdits ressorts (16).

5. Composant selon la revendication 2, caractérisé en ce que lesdits moyens élastiques (118, 118') sont collés sur lesdits couvercles (114, 114') ou lesdites plaques (103, 103').

6. Composant selon la revendication 2, caractérisé en ce que le volume défini entre ledit cadre (62), ladite plaque (53) et ledit couvercle (64) est rempli de mousse expansible (67).

7. Composant selon l'une des revendications précédentes, caractérisé en ce qu'il comprend deux plaques (103, 103') disposées de part et d'autre dudit boîtier (107) dudit échangeur de chaleur (106), ledit cadre (112) se prolongeant de part et d'autre desdites plaques et supportant deux couvercles (114, 114') aptes chacun à exercer un effort de poussée (F) sur une desdites plaques en direction d'une entretoise de dilatation (111, 111').

8. Procédé de fabrication d'un composant électronique de puissance (1 ; 51 ; 101) comprenant plusieurs puces (2 ; 52 ; 102, 102') de silicium supportées par une plaque (3 ; 53 ; 103, 103'), caractérisé en ce qu'il consiste à :
- disposer ladite plaque au contact d'une première face d'une entretoise de dilatation (11 ; 61 ; 111, 111') ;
- disposer un boîtier (7 ; 57 ; 107) d'un échangeur de chaleur au contact d'une seconde face de ladite entretoise ;
- surmouler l'ensemble (3, 7, 11 ; 61 ; 103, 103', 107, 111, 111') ainsi formé dans un matériau électriquement isolant (13 ; 63 ; 113) à l'intérieur d'un cadre (12 ; 62 ; 112) et
- monter sur ledit cadre au moins un couvercle (14 ; 64 ; 114, 114') apte à exercer sur ladite plaque un effort de poussée (F) en direction de ladite entretoise de dilatation.

9. Procédé selon la revendication 8, caractérisé en ce qu'il consiste à maintenir ledit ensemble (3, 7, 11 ; 53, 57, 61 ; 103, 103', 107, 111, 111') par rapport audit cadre (12, 62, 112) avant surmoulage par insertion d'au moins un raccord (9a, 10a ; 59a, 60a ; 109a, 110a) de connexion fluidique dudit boîtier (7 ; 57 ; 107) avec un circuit de circulation de fluide caloporteur (9, 10 ; 59, 60 ; 109, 110).

10. Procédé selon la revendication 8, caractérisé en ce qu'il consiste à introduire dans l'espace intérieur défini par ledit cadre (12 ; 62 ; 112), ladite plaque (3 ; 53 ; 103, 103') et ledit couvercle (14 ; 64 ; 114, 114') un moyen élastique (16 ; 67 ; 118, 118') de poussée sur ladite plaque.
